# EUROPEAN PATENT APPLICATION

(11) **EP 1 052 685 A2**
(43) Date of publication of application: **15.11.2000**
(21) Application number: 00303688.6
(22) Date of filing: 03.05.2000
(51) Int. Cl.: H01L 21/265, H01L 21/316, H01L 21/32, H01L 21/762

(54) **Integrated circuit device having a fluorine implanted oxide layer**

(30) Priority: 14.05.1999 US 311633
(71) Applicant: LUCENT TECHNOLOGIES INC., Murray Hill, New Jersey 07974-0636 (US)
(72) Inventor: Pearce, Charles Walter, Emmaus, PA 18049 (US); McKee, Daniel Joseph, Allentown, PA 18103 (US); Haas, Jeffrey Kenneth, Orefield, PA 18069 (US)
(74) Representative: Watts, Christopher Malcolm Kelway, Dr.

(57) **Abstract**

An integrated circuit device is disclosed which includes oxide regions formed by implantation of fluorine into the silicon lattice and subsequently forming an oxide region by a typical oxide growth process. The oxide growth process may be those such as thermal oxidation or the local oxidation of silicon. The device according to the present invention may be fabricated to have oxide layers having different thicknesses formulated at the same time by tailoring the fluorine implantation.

## Description

### Field Of The Invention

The present invention relates an integrated circuit device having an oxide layer implanted with fluorine. The oxide layers of the device are formed by implantation of fluorine into a material layer and subsequently forming an oxide region by a typical oxide growth process.

### Background Of The Invention

In the fabrication of a MOS (metal oxide semiconductor) semiconductor device, it is essential to form a gate oxide film by oxidation. The properties of a gate oxide film are greatly influenced by the atmosphere under which the film is formed. Accordingly, an oxide film can be deposited by processes differing from each other in atmospheric conditions. For instance, a silicon oxide film can be deposited by any of the processes belonging to, for example, the families of dry oxidation and wet oxidation. The dry oxidation process comprises supplying a sufficiently dried high purity oxygen to the surface of a hot silicon substrate. In this manner, a silicon oxide film can be formed on the surface of the silicon substrate. The wet oxidation process comprises supplying, to the surface of a silicon substrate, a hot carrier gas containing water vapor. This process also provides a silicon oxide film on the surface of the silicon substrate.

The presence of either chlorine or fluorine in an ambient of dry oxygen is known to accelerate the oxidation rate. It is known that a dry oxidation method to form a silicon oxide film under an oxidizing atmosphere based on a compound containing chlorine (e.g., HCl, Cl₂, CCl₄, C₂HCl₃, CH₂Cl₂, and C₂H₃Cl₃) or a compound containing a halogen atom other than chlorine provides a silicon oxide film which yields an oxide film thicker than that produced by the dry oxidation method alone. In this regard, fluorine is much more efficient than chlorine. Typically, chlorine is added as a percentage of the total oxygen flow, whereas fluorine on the order of parts-per-million will have a noticeable effect on the oxidation rate.

However, these prior art processes often require additional processing steps, such as annealing, to form a sufficient oxide layer. Additionally, the prior art methods do not allow the growth of the field oxide regions and the gate oxide regions during a single oxide growth step. The present invention overcomes the drawbacks of the prior art methods.

### Summary Of The Invention

The present invention relates to an integrated circuit device having oxide regions formed thereon my the implantation of fluorine into a material layer of the integrated circuit and subsequently forming an oxide region by a typical oxide growth process. The oxide growth process may be those such as dry or wet ambient thermal oxidation processes.

The oxide growth depends upon the amount of fluorine implanted into the substrate, the depth which the fluorine is implanted and the energy at which the fluorine is implanted. The device according to the present invention may also have oxide layers formed thereon having different thicknesses which were fabricated at the same time by tailoring the fluorine implantation into the material layer. Additional advantages of the present invention will be apparent from the detailed description and drawings, which illustrate preferred embodiments of the invention.

### Brief Description Of The Drawings

Figure 1 is a diagrammatic cross-sectional view of a semiconductor wafer according to a first embodiment of the present invention at an intermediate stage of processing.
Figure 2 is a diagrammatic cross-sectional view of a semiconductor wafer according to the present invention at a processing stage subsequent to that shown in Fig. 1.
Figure 3 is a diagrammatic cross-sectional view of a semiconductor wafer according to a second embodiment of the present invention at an intermediate stage of processing.
Figure 4 is a diagrammatic cross-sectional view of a semiconductor wafer according to the present invention at a processing stage subsequent to that shown in Fig. 3.
Figure 5 is a diagrammatic cross-sectional view of a semiconductor wafer according to the present invention at a processing stage subsequent to that shown in Fig. 4.
Figure 6 is a diagrammatic cross-sectional view of a semiconductor wafer according to a third embodiment of the present invention showing gate oxide layers having varying thickness.
Figure 7 is a diagrammatic cross-sectional view of a semiconductor wafer according to the present invention at a processing stage subsequent to that shown in Fig. 6.
Figure 8 is a diagrammatic cross-sectional view of a semiconductor wafer according to the present invention at a processing stage subsequent to that shown in Fig. 7.
Figure 9 is a diagrammatic cross-sectional view of a semiconductor wafer according to the present invention at a processing stage subsequent to that shown in Fig. 8.

### Detailed Description Of Preferred Embodiments

In the following detailed description, reference is made to the accompanying drawings which form a part hereof, and in which is shown by way of illustration specific embodiments in which the invention may be practiced. These embodiments are described in sufficient detail to enable those skilled in the art to practice the invention, and it is to be understood that other embodiments may be utilized, and that structural, logical and electrical changes may be made without departing from the spirit and scope of the present invention. The following detailed description is, therefore, not to be taken in a limiting sense, and the scope of the present invention is defined by the appended claims.

The terms "wafer" or "substrate" used in the following description may include any semiconductor-based structure or layer that has an exposed silicon surface. Wafer and structure must be understood to include silicon-on insulator (SOI), silicon-on sapphire (SOS), doped and undoped semiconductors, epitaxial layers of silicon supported by a base semiconductor foundation, and other semiconductor structures. The semiconductor need not be silicon-based. The semiconductor could be silicon-germanium, germanium, or gallium arsenide. When reference is made to a wafer or substrate in the following description, previous process steps may have been utilized to form regions or junctions in the base semiconductor or foundation.

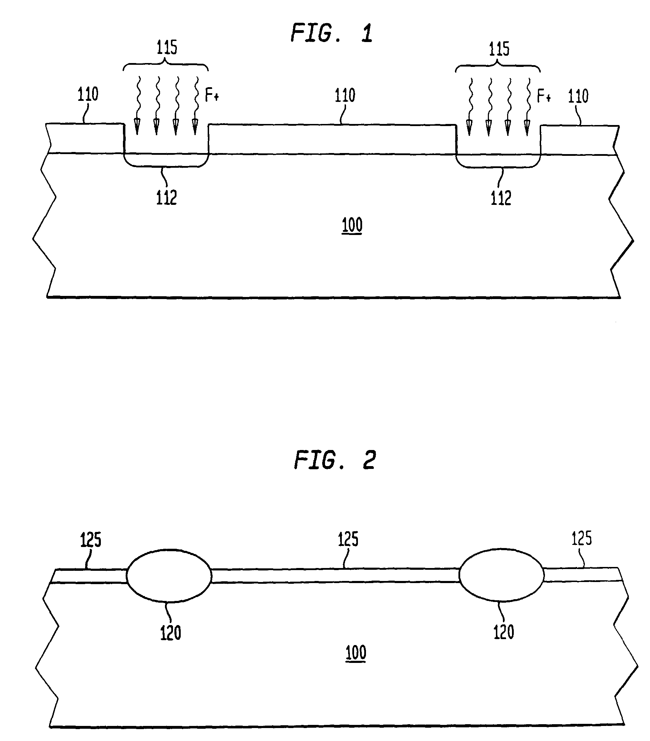

Referring now to the drawings, where like elements are designated by like reference numerals, a representative substrate formed according to the present invention is illustrated in Fig. 1 A substrate 100 is patterned with a pattern layer 110, preferably a photoresist mask, to create an area in the substrate where field oxide regions 120 will be formed. Fluorine is implanted into the surface of the substrate 100 as indicated by arrows 115. Preferably the fluorine atoms are implanted into the surface of the substrate 100 by ion implantation to form fluorine implant regions 112. The fluorine atoms are implanted using conventional implantation apparatus, such as ion implantation apparatus by methods known to the person having ordinary skill in the art.

The fluorine atoms are implanted into the substrate 100 at an amount of from about 1 x 10¹¹ atoms/cm² to about 5 x 10¹⁶ atoms/cm², preferably from about 5 x 10¹² atoms/cm² to about 7 x 10¹⁵ atoms/cm². The fluorine atoms are implanted at an energy of from about 1 KeV to about 1 MeV, preferably from about 10 KeV to about 50 KeV. The implantation energy together with the amount of fluorine atoms implanted determine the depth of the implantation. These three factors, amount, depth and implant energy, affect the amount of growth of the field oxide region 120.

The patterned layer 110 is removed and the implanted regions 112 of the substrate 100 are then oxidized to grow field oxide region 120 and gate oxide layer 125 is as shown in Fig. 2. Field oxide region 120 will preferably have a thickness of from about 1,000Å to about 10,000Å. Gate oxide layer 125 will have a thickness of from about 20Å to about 1,000Å, preferably from about 50Å to about 500Å. The field oxide region 120 and gate oxide region 125 will have a fluorine content of from about 1 x 10⁹ atoms/cm² to about 5 x 10¹⁴ atoms/cm², preferably from about 5 x 10¹⁰ atoms/cm² to about 7 x 10¹³ atoms/cm².

It should be understood that in an alternative embodiment, a second patterned layer (not shown) may be applied over substrate 100 and a fluorine layer may be implanted into the substrate 100 to grow the gate oxide layer 125 in selected regions of the substrate 100.

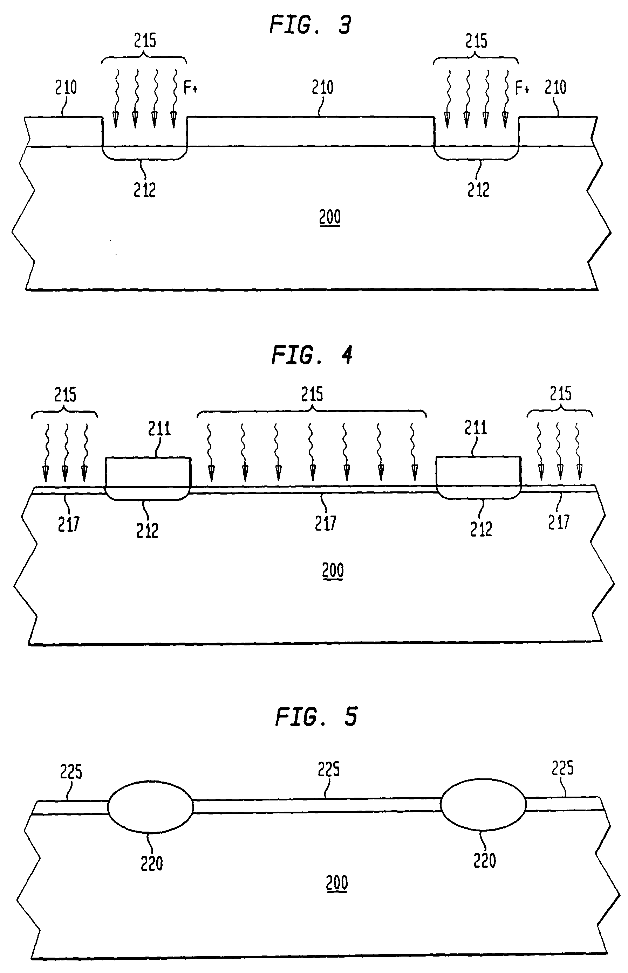

Referring now made to Fig. 3 which relates to a second embodiment of the present invention A substrate 200 is patterned with a pattern layer 210, preferably a photoresist mask, to create an area in the substrate where the field oxide region 220 (Fig. 5) will be formed. Fluorine is implanted into the surface of the substrate 200 as indicated by arrows 215. Preferably the fluorine atoms are implanted into the surface of the substrate 200 by ion implantation.

The fluorine atoms are implanted into the substrate 200 at an amount of from about 1 x 10¹¹ atoms/cm²to about 5 x 10¹⁶ atoms/cm², preferably from about 5 x 10¹² atoms/cm² to about 7 x 10¹⁵ atoms/cm². The fluorine atoms are implanted at an energy of from about 1 KeV to about 1 MeV, preferably from about 10 KeV to about 50 KeV. The implantation energy together with the amount of fluorine atoms implanted determine the depth of the implantation.

Reference is made to Fig. 4. The patterned layer 210 is removed. A second pattern layer 211 is applied to the substrate over the implanted regions 212. Fluorine is implanted into the surface of the substrate 210 as indicated by arrows 215. Again, the fluorine atoms are preferably implanted into the surface of the substrate 200 by ion implantation. The fluorine atoms may be implanted into the substrate 200 at an amount of from about 1 x 10¹¹ atoms/cm² to about 5 x 10¹⁶ atoms/cm², preferably from about 5 x 10¹² atoms/cm² to about 7 x 10¹⁵ atoms/cm²; however, it is generally understood that the fluorine implantation to form the gate oxide layer 225 (Fig. 5) is implanted at a lower level and to a shallower depth than the fluorine implantation to form field oxide regions 220.

The patterned layer 211 is removed and implanted regions 212, 217 of the substrate 200 are then oxidized to grow field oxide region 220 and gate oxide layer 225 as shown in Fig. 5. Field oxide region 220 will preferably have a thickness of from about 1,000Å to about 10,000Å. Gate oxide layer 225 will have a thickness of from about 20Å to about 1,000Å, preferably from about 50Å to about 500Å. The field oxide region 220 and gate oxide region 2125 will have a fluorine content of from about 1 x 10⁹ atoms/cm² to about 5 x 10¹⁴ atoms/cm², preferably from about 5 x 10¹⁰ atoms/cm² to about 7 x 10¹³ atoms/cm².

By using a single oxidation process without the need for a nitride masking layer, the present invention allows the gate oxide layer and the field oxide layer to be grown simultaneously.

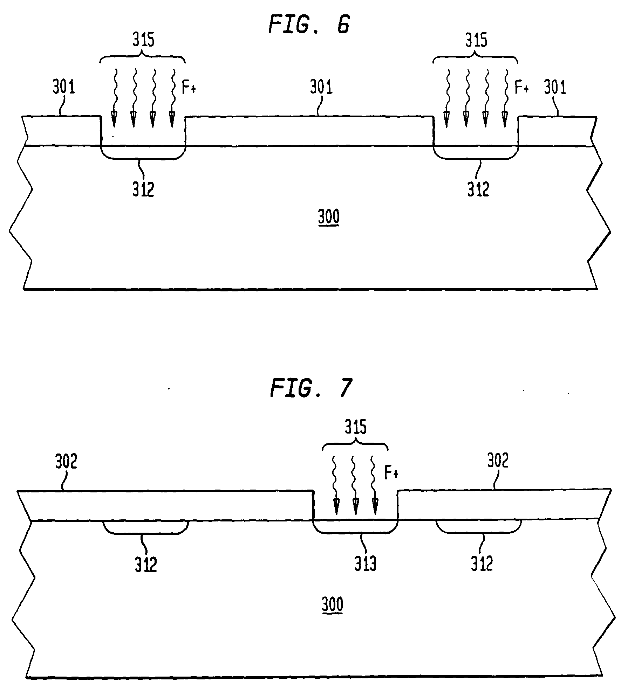

The process according to the present invention may also be used to grow gate oxides of different thicknesses allowing circuit operation at different voltages for different parts of the circuit as shown in Figs. 6-9. It should be understood from these figures that isolation regions may be formed in the device shown in these figures prior to the described processing. While these isolation regions have not depicted here, it is understood that they are within the scope of the present invention.

Reference is made to Fig. 6. To form the gate oxide regions having different thicknesses according to the present invention, a first mask 301 is place over substrate 300 and fluorine is implanted through the openings in the mask 301 at a predetermined dosage and energy level as shown by arrows 315 to form fluorine implantation region 312 as illustrated in Fig. 6. The mask 301 is removed and a second mask 302 is then applied and fluorine is then implanted in the openings in the second mask 302 at a predetermined dosage and energy level as shown by arrows 315 to form fluorine implantation region 313 as illustrated in Fig. 7. It should be understood that the dosage, energy of implantation and depth of implantation may be varied according to the thickness of the field oxide to be grown over substrate 300. While only two masks and corresponding fluorine implant regions have been illustrated, it should be understood that a plurality of masks and regions of varying fluorine implant dosage and depth may be formed according to the present invention.

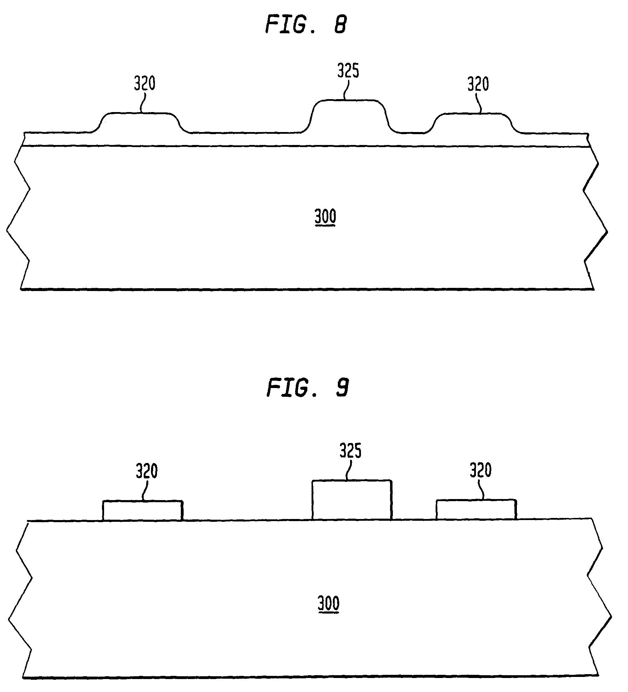

Reference is made to Fig. 8. The second mask 302 is removed and implanted regions 312, 313 of the substrate 300 are then oxidized using an a conventional thermal oxide process to grow gate oxide region 220, 225 having different thicknesses as shown in Fig. 8. The gate oxide regions 220 225 are then patterned and etched to arrive at the device illustrated in Fig. 9. Gate oxide regions 220, 225 will have a thickness of from about 20Å to about 1,000Å, preferably from about 50Å to about 500Å and a fluorine content of from about 1 x 10⁹ atoms/cm² to about 5 x 10¹⁴ atoms/cm², preferably from about 5 x 10¹⁰ atoms/cm² to about 7 x 10¹³ atoms/cm². It should be understood that further processing, such as formation of source/drain regions, deposition of further layers and the like may be performed to arrive at an operable integrated circuit device.

The present invention improves over the conventional methods for producing gate and other oxides having different thicknesses. One conventional method uses multiple oxidation steps where the unwanted oxide is removed by wet chemical etching in between the oxidation steps. This process generally results in a lack of control of at least one of the oxidation thicknesses and it is more difficult to control the differential between the desired thicknesses. Another approach is to use a single oxidation step and retard the oxidation of selected areas by nitrogen implantation. The present invention overcomes these shortcomings and produces gate oxides of differing thicknesses in a commercially efficient fabrication process.

The invention is further explained with reference to the following examples. These examples are merely provided for illustrative purposes and are not to be considered as limiting the invention.

Silicon wafers of (100) orientation and 125 mm diameter were doped with boron to a level of nominally 10¹⁵ atoms/cm² to arrive at a substrate having a p-type conductivity. The wafers were then implanted with F⁺ at implant levels from 5x10¹² to 7x10¹⁵ atoms/cm² as shown in Table 1 below. The implant energy in the examples was varied between about 10 and 50 KeV.

**TABLE 1**

| IMPLANT | DOPING LEVEL (ions/ cm²) | GATE OXIDE THICKNESS (Å) |
|---|---|---|
| Fluorine | 7x10¹⁵ | 162.86 |
| Fluorine | 7x10¹⁵ | 163.17 |
| Fluorine | 5x10¹⁵ | 169.29 |
| Fluorine | 5x10¹⁵ | 169.19 |
| Fluorine | 1x10¹⁵ | 134.21 |
| Fluorine | 1x10¹⁵ | 134.45 |
| Control | Control | 129.94 |
| Control | Control | 130.13 |
| Silicon | 1x10¹⁵ | 131.81 |
| Silicon | 1x10¹⁵ | 132.17 |
| Silicon | 5x10¹⁵ | 133.12 |
| Silicon | 5x10¹⁵ | 132.96 |

The fluorine implanted wafers receiving the various implants were oxidized in one of two processes along with control wafers which were only doped with the boron to form a conductivity type described above. One process used a conventional process used to grow 125Å oxide layers having an ambient of 98% oxygen and 2% HCl at 850°C on unimplanted wafers. A second process utilized an ambient of 100% oxygen at a temperature of 750°C.

As can be seen from the Table, the wafers implanted with fluorine exhibited greater growth than the control wafers. In fact, the wafers implanted with fluorine achieved an oxide thickness of up to 40Å greater than the control wafers. Additionally, the fluorine implanted wafers also had much greater oxide growth that wafers implanted with silicon ions. These results indicate that it is the fluorine dopant and not merely the presence of a dopant in the interstices of the silicon substrate aided in the unexpected growth of the oxide layer.

The largest differential achieved under these conditions was at an energy of 20 KeV and a dose of 1x10¹⁵ atoms/cm² of F⁺ where the percentage of increase was 28%. Profiles of the Fluorine by Secondary Ion Mass Spectroscopy (SIMS) indicated that, especially at the higher implant energies, only about 1% of the implanted dose was resident in the oxide layer. Thus, based on these results further optimization of dose, energy, and oxidation conditions could result in an oxidation differential of up to 900%. This technique can further be used in conjunction with nitrogen implantation, which is used to inhibit oxidation growth in the nitrogen implantation region, to achieve further oxidation growth differential.

The above illustrates preferred embodiments and examples which achieve the objects, features and advantages of the present invention. It is not intended that the present invention be limited to the illustrated embodiments. For example, while the present invention has been described with reference to a silicon integrated circuit device, it should be understood that the present invention may be used in any semiconductor substrate. Additionally, it should be understood that the method described is but one example of the methods that may be used in accordance with the present invention to form the integrated circuit device.

## Claims

1. An integrated circuit device having at least one oxide region formed thereon, said oxide region being formed by implanting fluorine into a substrate and thermally treating said substrate to form said oxide layer.

2. The device according to claim 1, wherein said oxide layer is an isolation region.

3. The device according to claim 1, wherein said oxide layer is a gate oxide layer

4. The device according to claim 1, wherein said fluorine is implanted in an amount of from about 1 x 10¹¹ atoms/cm² to about 5 x 10¹⁶ atoms/cm².

5. The device according to claim 1, wherein said fluorine is implanted in an amount of from about 5 x 10¹² atoms/cm² to about 7 x 10¹⁵ atoms/cm².

6. The device according to claim 1, wherein said device includes both isolation regions and gate oxide regions formed by implanting fluorine into said substrate and thermally treating said substrate.

7. The device according to claim 2, wherein said isolation region has a thickness of from about 1,000Å to about 10,000Å.

8. The device according to claim 3, wherein said gate oxide region has a thickness of from about 20Å to about 1,000Å.

9. The device according to claim 3, wherein said gate oxide has a thickness of from about 50Å to about 500Å.

10. The device according to claim 6, wherein said isolation region has a thickness of from about 1,000Å to about 10,000Å and said gate oxide region has a thickness of from about 20Å to about 1,000Å.

11. An integrated circuit device comprising:
a material layer which includes a fluorine implant; and
at least one oxide layer over said material layer.

12. The device according to claim 11, wherein said material layer is a silicon layer.

13. The device according to claim 12, wherein said oxide layer is an isolation region.

14. The device according to claim 12, wherein said oxide layer is a gate oxide layer

15. The device according to claim 11, wherein said fluorine is present in said material layer in an amount of from about 1 x 10⁹ atoms/cm² to about 5 x 10¹⁴ atoms/cm².

16. The device according to claim 11, wherein said fluorine is present in said material layer in an amount of from about 5 x 10¹⁰ atoms/cm² to about 7 x 10¹³ atoms/cm².

17. The device according to claim 12, wherein said fluorine is present in said silicon layer in an amount of from about 1 x 10⁹ atoms/cm² to about 5 x 10¹⁴ atoms/cm².

18. The device according to claim 12, wherein said fluorine is present in said silicon layer in an amount of from about 5 x 10¹⁰ atoms/cm² to about 7 x 10¹³ atoms/cm².

19. The device according to claim 11, wherein said oxide layer has a thickness of from about 20Å to about 10,000Å.

20. The device according to claim 11, wherein said oxide layer is an isolation region.

21. The device according to claim 11, wherein said oxide layer is a gate oxide layer

22. The device according to claim 20, wherein said isolation region has a thickness of from about 1,000Å to about 10,000Å.

23. The device according to claim 21, wherein said gate oxide layer has a thickness of from about 20Å to about 1,000Å.

24. The device according to claim 21, wherein said gate oxide has a thickness of from about 50Å to about 500Å.

25. The device according to claim 11, wherein said oxide layer includes both isolation regions and gate oxide regions formed by implanting fluorine into said substrate and thermally treating said substrate.

26. The device according to claim 25, wherein said isolation region has a thickness of from about 1,000Å to about 10,000Å and said gate oxide region has a thickness of from about 20Å to about 1,000Å.

27. The device according to claim 26, wherein said gate oxide region has a thickness of from about 50Å to about 500Å.

28. An integrated circuit device having at least a first and second oxide region formed thereon, said oxide regions being formed by implanting fluorine into a substrate in at least a first level, implanting fluorine into said substrate in at lease a second level and thermally treating said substrate to form said first and second oxide layers, wherein said first and second oxide regions have different thicknesses.

29. The device according to claim 28, wherein said first and second oxide regions are gate oxide regions.

30. The device according to claim 29, wherein said first and second oxide regions are silicon oxide regions.

31. The device according to claim 28, wherein said gate oxide regions have a thickness of between about 50Å to about 500Å and wherein said first gate oxide region is larger than said second gate oxide region.
